# EUROPEAN PATENT SPECIFICATION

(11) **EP 2 264 779 B1**
(45) Date of publication and mention of the grant of the patent: **05.09.2018**
(21) Application number: 09726493.1
(22) Date of filing: 25.03.2009
(51) Int. Cl.: H01L 31/05

(54) **SOLAR CELL, SOLAR CELL STRING AND SOLAR CELL MODULE**
SOLARZELLE, SOLARZELLENSTRANG UND SOLARZELLENMODUL
CELLULE SOLAIRE, CHAÎNE DE CELLULES SOLAIRES ET MODULE DE CELLULES SOLAIRES

(30) Priority: 31.03.2008 JP 2008092135
(43) Date of publication of application: 22.12.2010
(73) Proprietor: Sharp Kabushiki Kaisha, Osaka-shi, Osaka 545-8522 (JP)
(72) Inventor: HIOKI, Masaomi, Osaka-shi, Osaka 545-8522 (JP); NAKAMURA, Moritaka, Osaka-shi, Osaka 545-8522 (JP); UMETANI, Yoshinobu, Osaka-shi, Osaka 545-8522 (JP); OHBASAMI, Masahiro, Osaka-shi, Osaka 545-8522 (JP); ISHII, Mikiyasu, Osaka-shi, Osaka 545-8522 (JP); TANAKA, Satoshi, Osaka-shi, Osaka 545-8522 (JP); ISHII, Shuzo, Osaka-shi, Osaka 545-8522 (JP)
(74) Representative: Müller Hoffmann & Partner
(86) International application number: PCT/JP2009/055908
(87) International publication number: WO 2009/122977

(56) References cited:
- EP-A1- 1 870 942
- WO-A1-2007/060743
- WO-A1-2007/119365
- WO-A1-2008/139787
- JP-A- 11 298 019
- JP-A- 2005 150 540
- JP-A- 2007 287 861
- US-A1- 2005 133 084

## Description

### TECHNICAL FIELD

The present invention relates to a solar cell, a solar cell string and a solar cell module, and more particularly to a solar cell, a solar cell string and a solar cell module capable of achieving suppressed occurrence of a crack in a semiconductor substrate resulting from connection to a connecting member such as an interconnector.

In recent years, it has been hoped to develop clean energy against the backdrop of exhaustion of energy resources and global environmental problems such as increase in CO₂ in the atmosphere, and solar power generation using solar cells has particularly been developed and practically utilized, making continued progress.

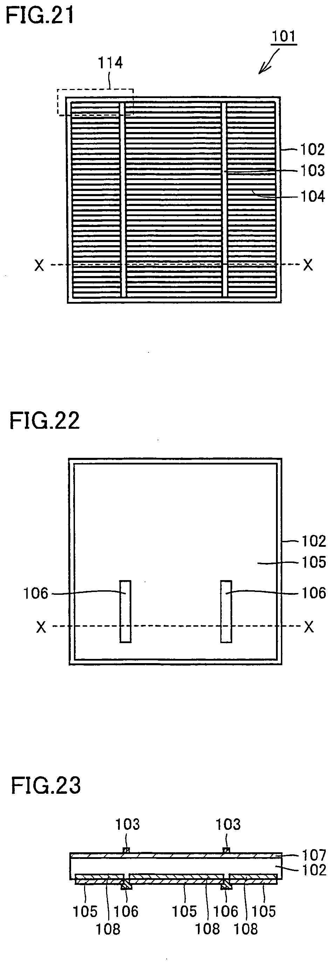

Fig. 21 shows a schematic plan view of a light-receiving surface of a conventional solar cell, Fig. 22 shows a schematic plan view of a rear surface of the conventional solar cell having the light-receiving surface shown in Fig. 21, and Fig. 23 shows a schematic cross section taken along the line X-X in Figs. 21 and 22 (see Japanese Patent Laying-Open No. 2003-224289 (Patent Document 1), for example).

As shown in Fig. 21, a conventional solar cell 101 includes a busbar electrode 103 extending in a strip shape in one direction, and a finger electrode 104 connected to busbar electrode 103 and extending in a direction orthogonal to the direction in which busbar electrode 103 extends, on a light-receiving surface of a p type silicon substrate 102 serving as a semiconductor substrate.

As shown in Fig. 22, conventional solar cell 101 includes a connecting electrode 106 in an island shape connected to a connecting member (not shown) of solar cell 101, and a peripheral electrode 105 formed to surround the periphery of connecting electrode 106, on a rear surface of p type silicon substrate 102.

As shown in Fig. 23, an n⁺ layer 107 is formed on the light-receiving surface of p type silicon substrate 102 by diffusion of an n type dopant, with busbar electrode 103 and finger electrode 104 being formed in contact with a surface of n⁺ layer 107 and electrically connected to each other. Generally, an antireflection coating (not shown) is formed on the surface of n⁺ layer 107. A p⁺ layer 108 is formed on the rear surface of p type silicon substrate 102 by diffusion of a p type dopant, with peripheral electrode 105 being formed in contact with a surface of p⁺ layer 108. Connecting electrode 106 is formed in contact with the rear surface of p type silicon substrate 102 between adjacent p⁺ layers 108.

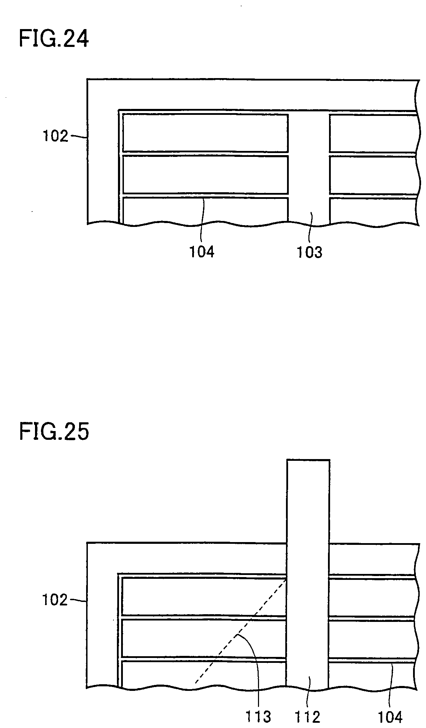

Fig. 24 shows a schematic enlarged plan view of an electrode pattern near an end portion of busbar electrode 103 on the light-receiving surface of conventional solar cell 101 shown in Fig. 21 (a region encircled with a broken line 114 in Fig. 21). WO 2007/119365 A1 relates to a solar cell, solar cell string and solar cell module. Disclosed is a solar cell comprising a semiconductor substrate having a photoelectric conversion section, a first electrode formed on a first major surface of the semiconductor substrate, and a second electrode connected to the first electrode on the first major surface. The first electrode comprises a plurality of first connecting portions to be connected with an interconnector and a first non-connecting portion which is not connected with the interconnector and arranged between the first connecting portions for electrically connecting them. The first connecting portions and the first non-connecting portion are joined together at an angle of more than 90° but less than 180°. Also disclosed are a solar cell string using such a solar cell, and a solar cell module. EP 1 870 942 A1 relates to a solar cell. The solar cell includes a photoelectric conversion layer, a first electrode on one surface of the photoelectric conversion layer, a second electrode provided on the other surface of the photoelectric conversion layer, and a third electrode provided on the other surface of the photoelectric conversion layer. The third electrode is substantially square with the corners rounded off in the in-plane direction of the photoelectric conversion layer, and overlaps the second electrode at the periphery thereof. Thus, in the solar cell, the separation of the third electrode is effectively prevented.
Patent Document 1: Japanese Patent Laying-Open No. 2003-224289

### DISCLOSURE OF THE INVENTION

### PROBLEMS TO BE SOLVED BY THE INVENTION

When busbar electrode 103 in the electrode pattern shown in Fig. 24 is electrically connected to the connecting member when making a solar cell string with a plurality of the conventional solar cells having the above structure, however, a crack 113 may occur in p type silicon substrate 102 in an oblique direction from a portion where a connecting member 112 such as an interconnector overlaps with an end portion of busbar electrode 103, as shown in Fig. 25. Accordingly, it has been hoped to suppress occurrence of such crack.

Conventionally, a semiconductor substrate used in a solar cell has had a large thickness, and thus a crack in the semiconductor substrate as described above has rarely occurred when making a solar cell string by connecting an electrode on the substrate to a connecting member such as an interconnector.

However, with substantial progress of reduction in thickness of a semiconductor substrate in recent years, occurrence of a crack in a semiconductor substrate during making of a solar cell string as described above has become a serious problem.

In view of the above circumstances, an object of the present invention is to provide a solar cell, a solar cell string and a solar cell module capable of achieving suppressed occurrence of a crack in a semiconductor substrate resulting from connection to a connecting member such as an interconnector.

### MEANS FOR SOLVING THE PROBLEMS

The invention is defined in independent claim 1. Further embodiments are defined in the dependent claims.

The present invention is directed to a solar cell including a semiconductor substrate, and a busbar electrode extending in a first direction and a finger electrode extending in a second direction on a first surface of the semiconductor substrate, the finger electrode and the busbar electrode being electrically connected to each other, and a side portion of the busbar electrode being curved such that a width of the busbar electrode increases toward an end portion of the busbar electrode, in a region near the end portion of the busbar electrode in the first direction.

A side portion of the finger electrode is curved such that a width of the finger electrode increases toward a connection portion between the finger electrode and the busbar electrode, in a region near the connection portion between the finger electrode and the busbar electrode.

Preferably, in the solar cell of the present invention, an angle formed between the first direction and the second direction is a right angle or substantially a right angle.

Preferably, the solar cell of the present invention further includes on a second surface opposite to the first surface of the semiconductor substrate, a connecting electrode provided in an island shape for being electrically connected to a connecting member of the solar cell, and a peripheral electrode provided to surround a periphery of the connecting electrode, in which a side portion of the connecting electrode is curved such that a width of the connecting electrode decreases toward an end portion of the connecting electrode in the first direction, in a region near the end portion of the connecting electrode.

Preferably, in the solar cell of the present invention, the peripheral electrode is positioned on the second surface, in a portion corresponding to the back of the end portion of the busbar electrode in the first direction on the first surface of the semiconductor substrate.

Preferably, in the solar cell of the present invention, the connecting electrode is not positioned on the second surface, in a portion corresponding to the back of the end portion of the busbar electrode in the first direction on the first surface of the semiconductor substrate.

Preferably, in the solar cell of the present invention, the width of at least a portion of the connecting electrode on the second surface of the semiconductor substrate is larger than the width of the busbar electrode in a region other than the region near the end portion of the busbar electrode on the first surface of the semiconductor substrate.

Preferably, in the solar cell of the present invention, the connecting electrode contains silver. Preferably, in the solar cell of the present invention, the peripheral electrode contains aluminum.

The present invention is also directed to a solar cell string including a plurality of the solar cells described above. The present invention is also directed to a solar cell module including the solar cell string described above.

### EFFECTS OF THE INVENTION

According to the present invention, a solar cell, a solar cell string and a solar cell module capable of achieving suppressed occurrence of a crack in a semiconductor substrate resulting from connection to a connecting member such as an interconnector can be provided.

### BRIEF DESCRIPTION OF THE DRAWINGS

Fig. 1 is a schematic plan view of a first surface of a semiconductor substrate of an example of a solar cell in the present invention.
Fig. 2 is a schematic plan view of a second surface of the semiconductor substrate of the solar cell shown in Fig. 1.
Fig. 3 is a schematic cross-sectional view taken along the line A-A in Figs. 1 and 2.
Fig. 4 is a schematic cross-sectional view taken along the line B-B in Figs. 1 and 2.
Fig. 5 is a schematic enlarged plan view of an example not part of the invention of an electrode pattern in a portion encircled with a broken line in Fig. 1.
Fig. 6 is a schematic enlarged plan view showing an example not part of the invention of a state where a busbar electrode shown in Fig. 5 is connected to a connecting member.
Fig. 7 is a schematic enlarged plan view of an embodiment according to the invention of the electrode pattern in the portion encircled with the broken line in Fig. 1.
Fig. 8 is a schematic enlarged plan view of an example not part of the invention of the electrode pattern in the portion encircled with the broken line in Fig. 1.
Fig. 9 is a schematic enlarged plan view of another embodiment according to the invention of the electrode pattern in the portion encircled with the broken line in Fig. 1.
Fig. 10 is a schematic plan view of another example of the second surface of the semiconductor substrate of the solar cell shown in Fig. 1.
Fig. 11 is a schematic enlarged plan view of an example of a portion encircled with a broken line in Fig. 10.
Fig. 12 is a schematic plan view of another example of the second surface of the semiconductor substrate of the solar cell shown in Fig. 1.
Fig. 13 is a schematic enlarged plan view of an example of a portion encircled with a broken line in Fig. 12.
Fig. 14 is a schematic cross-sectional view taken along the line C-C in Figs. 10 and 12.
Fig. 15 is a schematic cross-sectional view taken along the line D-D in Figs. 10 and 12.
Fig. 16 shows a flowchart of an example of a method for manufacturing the solar cell of the present invention.
Fig. 17(a) is a schematic plan view of an example of light-receiving surfaces of a solar cell string of the present invention, which is made by connecting a plurality of the solar cells of the present invention to each other with connecting members. Fig. 17(b) is a schematic plan view of an example of rear surfaces of the solar cell string shown in Fig. 17(a). Fig. 17(c) is a schematic cross-sectional view of the solar cell string having the light-receiving surfaces shown in Fig. 17(a) and the rear surfaces shown in Fig. 17(b).
Fig. 18(a) is a schematic plan view of another example of the light-receiving surfaces of the solar cell string of the present invention, which is made by connecting the plurality of the solar cells of the present invention to each other with the connecting members. Fig. 18(b) is a schematic plan view of another example of the rear surfaces of the solar cell string shown in Fig. 18(a). Fig. 18(c) is a schematic cross-sectional view of the solar cell string having the light-receiving surfaces shown in Fig. 18(a) and the rear surfaces shown in Fig. 18(b).
Fig. 19(a) is a schematic plan view of another example of the light-receiving surfaces of the solar cell string of the present invention, which is made by connecting the plurality of the solar cells of the present invention to each other with the connecting members. Fig. 19(b) is a schematic plan view of another example of the rear surfaces of the solar cell string shown in Fig. 19(a). Fig. 19(c) is a schematic cross-sectional view of the solar cell string having the light-receiving surfaces shown in Fig. 19(a) and the rear surfaces shown in Fig. 19(b).
Fig. 20 shows a flowchart of an example of a method for manufacturing a solar cell module of the present invention.
Fig. 21 is a schematic plan view of a light-receiving surface of a conventional solar cell.
Fig. 22 is a schematic plan view of a rear surface of the conventional solar cell having the light-receiving surface shown in Fig. 21.
Fig. 23 is a schematic cross-sectional view taken along the line X-X in Figs. 21 and 22.
Fig. 24 is a schematic enlarged plan view of an electrode pattern near an end portion of a busbar electrode on the light-receiving surface of the conventional solar cell shown in Fig. 23.
Fig. 25 is a schematic enlarged view illustrating occurrence of a crack in a semiconductor substrate when the busbar electrode shown in Fig. 24 is connected to a connecting member.

### DESCRIPTION OF THE REFERENCE SIGNS

1, 101 solar cell; 2 semiconductor substrate; 3, 103 busbar electrode; 3a busbar electrode end curved portion; 3b end portion; 4, 104 finger electrode; 4a finger electrode end curved portion; 5, 105 peripheral electrode; 6, 106 connecting electrode; 6a connecting electrode end curved portion; 6b whisker electrode; 7, 107 n⁺ layer; 8, 108 p⁺ layer; 10 near-end-portion electrode; 12, 112 connecting member; 15 antireflection coating; 17 opening; 50 first direction; 51 second direction; 102 p type silicon substrate; 113 crack; 114 broken line.

### BEST MODES FOR CARRYING OUT THE INVENTION

An embodiment of the present invention will be described below. It is noted that the same or corresponding parts have the same reference signs allotted in the drawings of the present invention.

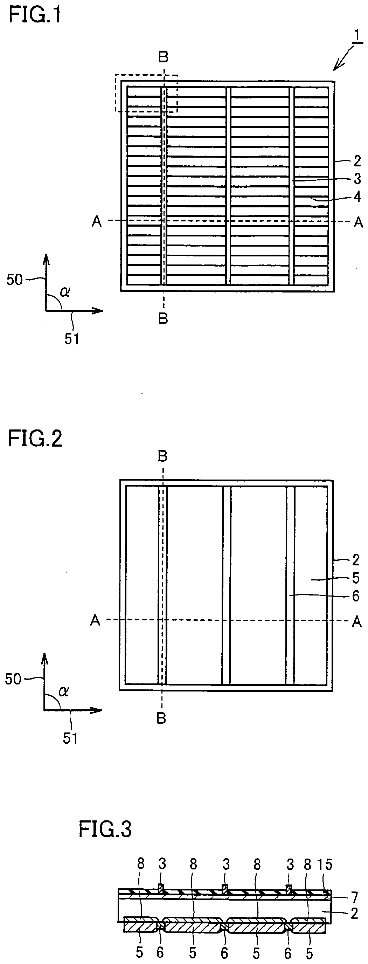

Fig. 1 shows a schematic plan view of an example of a first surface of a semiconductor substrate of a solar cell of the present invention. A solar cell 1 includes a semiconductor substrate 2, and a busbar electrode 3 extending in a first direction 50 and a finger electrode 4 extending in a second direction 51 on a first surface of semiconductor substrate 2. Busbar electrode 3 is electrically connected to a plurality of finger electrodes 4. The first surface of semiconductor substrate 2 having this structure can serve as a light-receiving surface of a solar cell, which is a main surface sunlight enters.

Semiconductor substrate 2 is not particularly limited, and a substrate made of a conventionally known semiconductor, e.g., a p type or n type silicon substrate may be used. While the present specification describes a case where a p type silicon substrate is used as semiconductor substrate 2, semiconductor substrate 2 is naturally not limited to a p type silicon substrate.

Busbar electrode 3 is not particularly limited as long as it is made of a conductive substance, and silver may be used, for example. While the present specification describes a case where busbar electrode 3 extends in a strip shape in first direction 50, busbar electrode 3 is not limited as such.

Finger electrode 4 is not particularly limited, either, as long as it is made of a conductive substance, and silver may be used, for example. While the present specification describes a case where finger electrode 4 extends in a strip shape in second direction 51, finger electrode 4 is not limited as such.

It is preferable that an angle α formed between first direction 50 and second direction 51 is a right angle or substantially a right angle. The "right angle" means that angle α formed between first direction 50 and second direction 51 is set to 90°, and the "substantially a right angle" means that angle α formed between first direction 50 and second direction 51 is set to 87° or more but less than 90°, or more than 90° but 93° or less.

In the present specification, first direction 50 shall mean a direction the same as an arrow in the drawings, a direction opposite to the arrow in the drawings, or both directions the same as and opposite to the arrow in the drawings. In the present specification, second direction 51 shall also mean a direction the same as an arrow in the drawings, a direction opposite to the arrow in the drawings, or both directions the same as and opposite to the arrow in the drawings.

Fig. 2 shows a schematic plan view of an example of a second surface of semiconductor substrate 2 of solar cell 1 shown in Fig. 1. The second surface of semiconductor substrate 2 is a surface opposite to the first surface of semiconductor substrate 2 shown in Fig. 1.

On the second surface of semiconductor substrate 2 of solar cell 1, a connecting electrode 6 extending in a strip shape in first direction 50 and a peripheral electrode 5 lying between adjacent connecting electrodes 6 and extending in a strip shape in first direction 50 are provided. Peripheral electrode 5 is formed such that a portion of peripheral electrode 5 overlaps connecting electrode 6 in order to obtain electrical connection to connecting electrode 6. The second surface of semiconductor substrate 2 having this structure can serve as a rear surface of the solar cell opposite to the light-receiving surface.

Peripheral electrode 5 is not particularly limited as long as it is made of a conductive substance, and aluminum may be used, for example. It is particularly preferable to use a conductive substance containing aluminum for peripheral electrode 5.

Connecting electrode 6 is not particularly limited as long as it is made of a conductive substance, and silver may be used, for example. It is particularly preferable to use a conductive substance containing silver for connecting electrode 6.

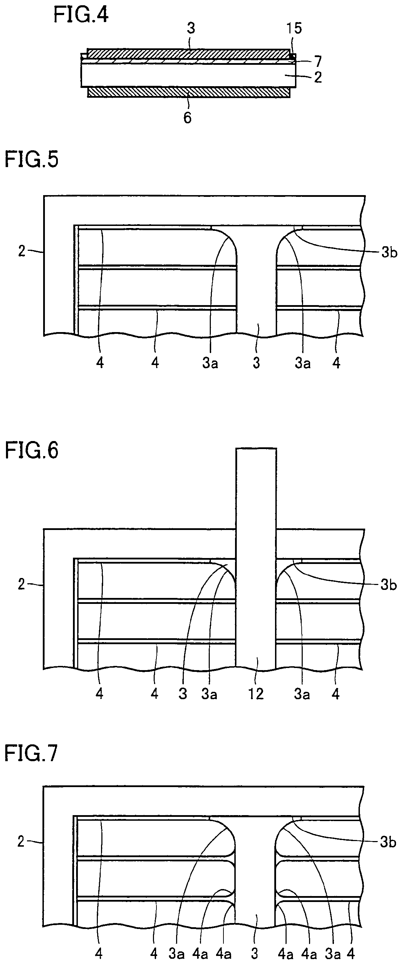

Fig. 3 schematically shows a cross section taken along the line A-A in Figs. 1 and 2, and Fig. 4 schematically shows a cross section taken along the line B-B in Figs. 1 and 2. As shown in Fig. 3, an n⁺ layer 7 formed by diffusion of an n type impurity is formed in the first surface of semiconductor substrate 2. Busbar electrode 3 and an antireflection coating 15 are formed in contact with n⁺ layer 7 in the first surface of semiconductor substrate 2. Finger electrode 4 (not shown in Figs. 3 and 4) is also formed on n⁺ layer 7 in the first surface of semiconductor substrate 2, and is electrically connected to busbar electrode 3.

A p⁺ layer 8 formed by diffusion of a p type impurity is formed in the second surface of semiconductor substrate 2. Peripheral electrode 5 is formed in contact with p⁺ layer 8 in the second surface of semiconductor substrate 2, and connecting electrode 6 is formed to overlap a portion of peripheral electrode 5 in the second surface of semiconductor substrate 2.

As shown in Fig. 4, connecting electrode 6 is formed on the second surface of semiconductor substrate 2, in a portion corresponding to the back of busbar electrode 3 on the first surface of semiconductor substrate 2.

Fig. 5 shows a schematic enlarged plan view of an example of an electrode pattern in a portion encircled with a broken line in Fig. 1.

A feature of solar cell 1 of the present invention is that a side portion of busbar electrode 3 is curved (this curved portion is referred to as a busbar electrode end curved portion 3a) such that a width of busbar electrode 3 increases toward an end portion 3b of busbar electrode 3, in a region near the end portion of busbar electrode 3 in first direction 50.

With this structure, even when busbar electrode 3 is connected to a connecting member 12 such as an interconnector with solder or the like to connect a plurality of solar cells 1 to make a solar cell string, as shown in a schematic enlarged plan view of Fig. 6, for example, occurrence of a crack in semiconductor substrate 2 from a connection portion between connecting member 12 and busbar electrode 3 can be suppressed as compared to conventional solar cell 101 without busbar electrode end curved portion 3a shown in Fig. 21. The reason for the suppression may be because stress generated in semiconductor substrate 2 due to the difference in thermal expansion coefficient between connecting member 12 such as an interconnector and semiconductor substrate 2 can be relaxed by busbar electrode end curved portion 3a of busbar electrode 3.

In the above description, it is preferable that end portion 3b of busbar electrode 3 of solar cell 1 is an end portion on a side adjacent to another solar cell 1, when connecting busbar electrode 3 of solar cell 1 to connecting electrode 6 on a rear surface of the another solar cell 1 in series with connecting member 12 such as an interconnector.

The region near the end portion of busbar electrode 3 means a region of busbar electrode 3 from end portion 3b of busbar electrode 3 toward busbar electrode 3 by 2.5 mm in a direction parallel to first direction 50.

Busbar electrode end curved portion 3a should only exist in at least a portion of the region near the end portion of busbar electrode 3.

If busbar electrode end curved portion 3 a is curved in the form of an arc of a circle of curvature, a radius of curvature thereof is not particularly limited, and may be approximately 0.5 mm, for example.

The width of busbar electrode 3 means a length of busbar electrode 3 in a direction orthogonal to first direction 50.

In the above description, connecting member 12 is not particularly limited as long as it is made of a conductive substance, and an interconnector which has been conventionally used in the field of solar cells may be used as appropriate, for example.

Fig. 7 shows a schematic enlarged plan view of an embodiment of the electrode pattern in the portion encircled with the broken line in Fig. 1. A feature of this embodiment is that busbar electrode end curved portion 3a, which is the side portion of busbar electrode 3 curved such that the width of busbar electrode 3 increases is provided in the region near the end portion of busbar electrode 3, and further that a finger electrode end curved portion 4a, which is a side portion of finger electrode 4 curved such that a width of finger electrode 4 increases toward a connection portion between finger electrode 4 and busbar electrode 3 is provided in a region near the connection portion between finger electrode 4 and busbar electrode 3.

With this structure, occurrence of a crack in semiconductor substrate 2 from the connection portion between connecting member 12 and busbar electrode 3 can be suppressed during making of a solar cell string, and occurrence of a crack in semiconductor substrate 2 in the region near the connection portion between finger electrode 4 and busbar electrode 3 can also be suppressed. The reason for the suppression may be because stress generated in semiconductor substrate 2 due to the difference in thermal expansion coefficient between connecting member 12 such as an interconnector and semiconductor substrate 2 can be relaxed by finger electrode end curved portion 4a in the region near the connection portion between busbar electrode 3 and finger electrode 4. In addition, by providing finger electrode end curved portion 4a, disconnection between finger electrode 4 and busbar electrode 3 tends to be suppressed when finger electrode 4 is formed by screen printing or the like.

The region near the connection portion between finger electrode 4 and busbar electrode 3 means a region of finger electrode 4 from the connection portion between finger electrode 4 and busbar electrode 3 toward finger electrode 4 by 0.5 mm in a direction parallel to second direction 51.

Finger electrode end curved portion 4a in the region near the connection portion between finger electrode 4 and busbar electrode 3 should only exist in at least a portion of the region near the connection portion between finger electrode 4 and busbar electrode 3.

If finger electrode end curved portion 4a is curved in the form of an arc of a circle of curvature, a radius of curvature thereof is not particularly limited, and may be approximately 0.5 mm, for example.

The width of finger electrode 4 means a length of finger electrode 4 in a direction orthogonal to second direction 51.

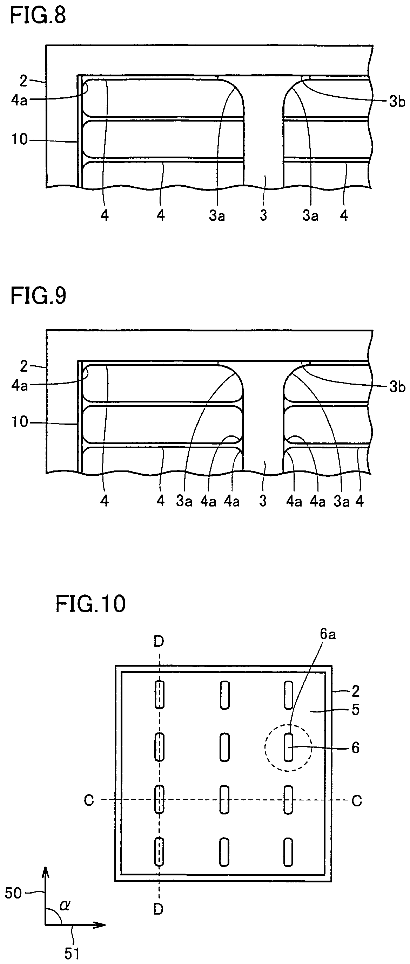

Fig. 8 shows a schematic enlarged plan view of another example of the electrode pattern in the portion encircled with the broken line in Fig. 1. A feature of this example is that busbar electrode end curved portion 3a, which is the side portion of busbar electrode 3 curved such that the width of busbar electrode 3 increases toward end portion 3b of busbar electrode 3 is provided in the region near the end portion of busbar electrode 3, and further that finger electrode end curved portion 4a, which is a side portion of finger electrode 4 curved such that the width of finger electrode 4 increases toward a connection portion between a near-end-portion electrode 10 and finger electrode 4 is provided in a region near the connection portion between near-end-portion electrode 10 and finger electrode 4.

With this structure, occurrence of a crack in semiconductor substrate 2 from the connection portion between connecting member 12 and busbar electrode 3 can be suppressed during making of a solar cell string, and stress concentration on semiconductor substrate 2 can be relaxed by finger electrode end curved portion 4a, which is considered to reduce occurrence of a crack in semiconductor substrate 2. In addition, by providing finger electrode end curved portion 4a, disconnection between finger electrode 4 and near-end-portion electrode 10 tends to be suppressed when finger electrode 4 is formed by screen printing or the like.

The region near the connection portion between near-end-portion electrode 10 and finger electrode 4 means a region of finger electrode 4 from the connection portion between near-end-portion electrode 10 and finger electrode 4 toward finger electrode 4 by 0.5 mm in the direction parallel to second direction 51.

Finger electrode end curved portion 4a in the region near the connection portion between near-end-portion electrode 10 and finger electrode 4 should only exist in at least a portion of the region near the connection portion between near-end-portion electrode 10 and finger electrode 4.

If finger electrode end curved portion 4a in the region near the connection portion between near-end-portion electrode 10 and finger electrode 4 is curved in the form of an arc of a circle of curvature, a radius of curvature thereof is not particularly limited, and may be approximately 0.5 mm, for example.

Fig. 9 shows a schematic enlarged plan view of another embodiment of the electrode pattern in the portion encircled with the broken line in Fig. 1. In this embodiment, busbar electrode end curved portion 3a, finger electrode end curved portion 4a in the region near the connection portion between finger electrode 4 and busbar electrode 3, and finger electrode end curved portion 4a in the region near the connection portion between finger electrode 4 and near-end-portion electrode 10 described above are all included.

This structure is preferable in that occurrence of a crack in all of the following cases (1) to (3) can be suppressed during making of a solar cell string, and that disconnection between the above-described electrodes tends to be suppressed when the electrodes are formed with screen printing or the like.
(1) Occurrence of a crack in semiconductor substrate 2 from the connection portion between connecting member 12 and busbar electrode 3.
(2) Occurrence of a crack in semiconductor substrate 2 in the region near the connection portion between finger electrode 4 and busbar electrode 3.
(3) Occurrence of a crack in semiconductor substrate 2 in the region near the connection portion between near-end-portion electrode 10 and finger electrode 4.

While the respective structures shown in Figs. 5 and 7 to 9 should only be implemented in at least one location on the first surface of semiconductor substrate 2 of solar cell 1 in the present invention, it is preferable for the structures to be implemented in many locations, and most preferable for the structures to be implemented in all appropriate locations on the first surface of semiconductor substrate 2 of solar cell 1.

Fig. 10 shows a schematic plan view of another example of the second surface of semiconductor substrate 2 of solar cell 1 shown in Fig. 1. In this example, connecting electrode 6 is provided in an island shape, and peripheral electrode 5 is provided to surround the periphery of connecting electrode 6 in an island shape. A feature of this example is that a connecting electrode end curved portion 6a, which is a side portion of connecting electrode 6 curved such that a width of connecting electrode 6 decreases toward an end portion of connecting electrode 6 in first direction 50 is provided in a region near the end portion of connecting electrode 6.

The region near the end portion of connecting electrode 6 means a region of connecting electrode 6 from the end portion of connecting electrode 6 in first direction 50 toward connecting electrode 6 by 2 mm in the direction parallel to first direction 50.

Connecting electrode end curved portion 6a should only exist in at least a portion of the region near the end portion of connecting electrode 6.

If connecting electrode end curved portion 6a is curved in the form of an arc of a circle of curvature, a radius of curvature thereof is not particularly limited, and may be approximately 1.5 mm, for example.

The width of connecting electrode 6 means a length of connecting electrode 6 in the direction orthogonal to first direction 50.

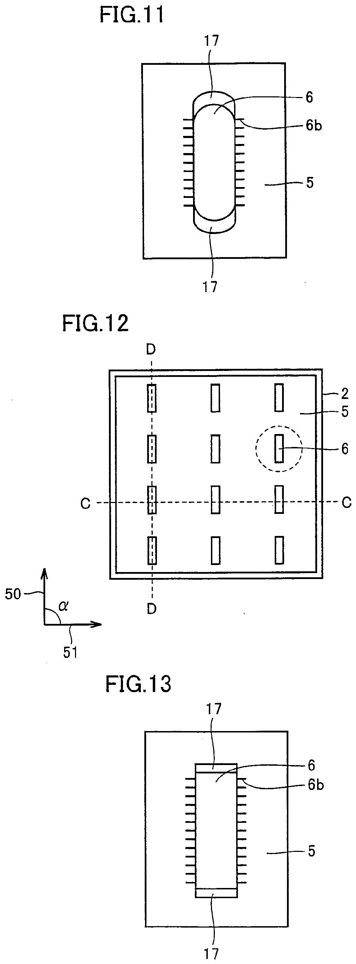

Fig. 11 shows a schematic enlarged plan view of an example of a portion encircled with a broken line in Fig. 10. An opening 17 where connecting electrode 6 and peripheral electrode 5 are not formed is provided between connecting electrode 6 and peripheral electrode 5 in first direction 50. Further, a whisker electrode 6b for reinforcing electrical connection between connecting electrode 6 and peripheral electrode 5 is provided from a side portion of connecting electrode 6 toward peripheral electrode 5. Whisker electrode 6b is not particularly limited as long as it is made of a conductive substance, and a material the same as that for connecting electrode 6, such as silver, may be used, for example.

Fig. 12 shows a schematic plan view of another example of the second surface of semiconductor substrate 2 of solar cell 1 shown in Fig. 1. A feature of this example is that connecting electrode 6 in an island shape is formed having a constant width.

Fig. 13 shows a schematic enlarged plan view of a portion encircled with a broken line in Fig. 12. Again, in this example, opening 17 where connecting electrode 6 and peripheral electrode 5 are not formed is provided between connecting electrode 6 and peripheral electrode 5 in first direction 50. Further, whisker electrode 6b for reinforcing electrical connection between connecting electrode 6 and peripheral electrode 5 is provided from a side portion of connecting electrode 6 toward peripheral electrode 5.

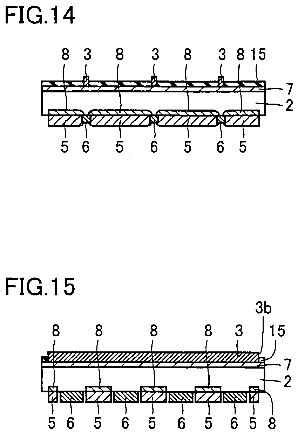

Fig. 14 schematically shows a cross section taken along the line C-C in Figs. 10 and 12, and Fig. 15 schematically shows a cross section taken along the line D-D in Figs. 10 and 12. While the cross section taken along the line C-C shown in Fig. 14 has a similar structure to the cross section shown in Fig. 3, the cross section taken along the line D-D shown in Fig. 15 has a different structure from the cross section shown in Fig. 4.

That is, as shown in Fig. 15, p⁺ layers 8 are formed at prescribed intervals on the second surface of semiconductor substrate 2, with peripheral electrodes 5 being formed on p⁺ layers 8. Connecting electrode 6 is formed in a region between p⁺ layers 8 on the second surface of semiconductor substrate 2.

P⁺ layer 8 can be formed by drying an aluminum paste that has been printed into a prescribed pattern by screen printing or the like at a temperature of approximately 200°C, and then firing the paste at a temperature of approximately 700 to 800°C to diffuse aluminum serving as a p type dopant into semiconductor substrate 2. When p⁺ layer 8 is formed in this manner, an alloy layer containing aluminum and silicon (not shown) is formed between p⁺ layer 8 and peripheral electrode 5. This alloy layer is dense, and thus has the effect of reinforcing semiconductor substrate 2.

In solar cell 1 of the present invention, as shown in Fig. 15, for example, it is preferable that peripheral electrode 5 is positioned (i.e., connecting electrode 6 is not positioned) on the second surface, in a portion corresponding to the back of end portion 3b of busbar electrode 3 in first direction 50 on the first surface of semiconductor substrate 2. If peripheral electrode 5 is made of a conductive substance containing aluminum, the dense alloy layer containing aluminum and silicon described above is formed, thereby reinforcing semiconductor substrate 2 by this alloy layer. If connecting electrode 6 made of a conductive substance containing silver is positioned on the second surface, in the portion corresponding to the back of end portion 3b of busbar electrode 3 in first direction 50 on the first surface of semiconductor substrate 2, the alloy layer described above is not formed, which may result in lower effect of reinforcing semiconductor substrate 2.

Further, it is preferable that the width of at least a portion of connecting electrode 6 on the second surface of semiconductor substrate 2 is larger than the width of busbar electrode 3 in a region other than the region near the end portion of busbar electrode 3 on the first surface of semiconductor substrate 2. By making the width of at least a portion of connecting electrode 6 on the second surface of solar cell 1 larger than the width of busbar electrode 3 on the first surface of solar cell 1 in this manner, connection stability in connecting connecting member 12 that has been connected to busbar electrode 3 to connecting electrode 6 can be improved when making a solar cell string with connecting member 12 such as an interconnector as described later.

Moreover, it is preferable for connecting electrode 6 on the second surface of semiconductor substrate 2 of solar cell 1 to have the structure including connecting electrode end curved portion 6a, which is the side portion of connecting electrode 6 curved such that the width of connecting electrode 6 decreases toward the end portion of connecting electrode 6 in first direction 50, as shown in Figs. 10 and 11, for example. With this structure, occurrence of a crack in semiconductor substrate 2 from a connection portion between connecting member 12 and connecting electrode 6 tends to be suppressed during making of a solar cell string. The reason for the suppression may be because stress generated in semiconductor substrate 2 resulting from the difference in thermal expansion coefficient between connecting member 12 such as an interconnector and semiconductor substrate 2 during making of the solar cell string can be relaxed by connecting electrode end curved portion 6a.

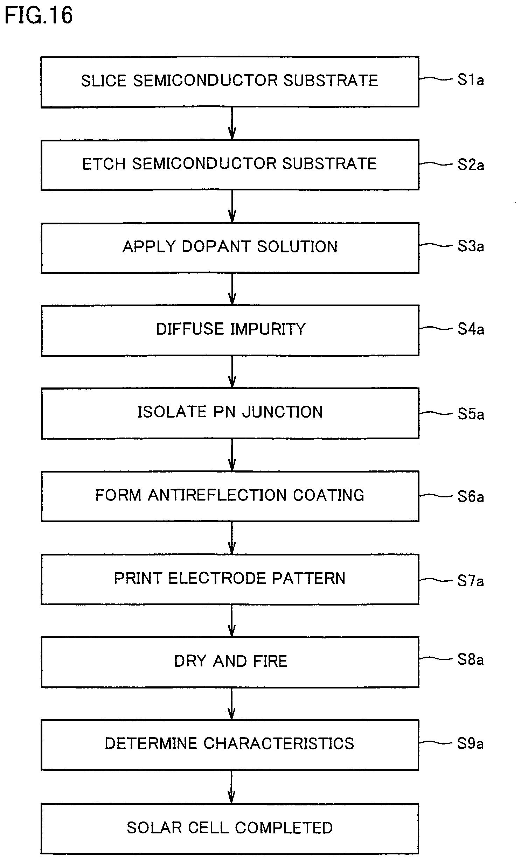

Fig. 16 shows a flowchart of an example of a method for manufacturing solar cell 1 of the present invention described above. First, as shown in step S1a, semiconductor substrate 2 serving as a p type silicon substrate is sliced from a p type silicon crystal ingot, for example, which was manufactured with a conventionally known method.

Next, as shown in step S2a, a surface of semiconductor substrate 2 that was sliced from the p type silicon crystal ingot is etched, to remove a damaged layer formed during the slicing and form a texture structure on the first surface of semiconductor substrate 2.

Next, as shown in step S3a, a dopant solution containing an n type dopant is applied to the first surface of semiconductor substrate 2. Phosphorus may be used, for example, as the n type dopant.

Next, as shown in step S4a, the n type dopant is diffused into the first surface of semiconductor substrate 2 by heating semiconductor substrate 2 to which the above dopant solution was applied, for example. As a result, n⁺ layer 7 is formed on the first surface of semiconductor substrate 2.

Next, as shown in step S5a, a pn junction is isolated by removing a portion of n⁺ layer 7 that was formed to wrap around a side surface of semiconductor substrate 2. The pn junction may be isolated with any one of a method for pn junction isolation by cutting a trench with laser light in an end portion of semiconductor substrate 2, a method for etching only one of the surfaces of semiconductor substrate 2, and a method for diffusing an n type dopant after forming a protective film on one of the surfaces of semiconductor substrate 2, or the like.

Next, as shown in step S6a, antireflection coating 15 is formed on the first surface of semiconductor substrate 2. A silicon nitride film or the like may be formed with plasma CVD, for example, as antireflection coating 15.

Next, as shown in step S7a, on the first surface of semiconductor substrate 2, a conductive paste such as a silver paste is printed by screen printing or the like into the electrode pattern of busbar electrode 3 and finger electrode 4 described above. In addition, on the second surface of semiconductor substrate 2, a conductive paste such as a silver paste is printed by screen printing or the like into the electrode pattern of connecting electrode 6 described above, and a conductive paste such as an aluminum paste is printed by screen printing or the like into the electrode pattern of peripheral electrode 5.

Next, as shown in step S8a, the conductive pastes that have been printed on the first surface and the second surface of semiconductor substrate 2 are dried and then fired. As a result, busbar electrode 3 and finger electrode 4 are formed on n⁺ layer 7 by fire through and electrically connected to each other on the first surface of semiconductor substrate 2. In addition, connecting electrode 6 and peripheral electrode 5 are formed on the second surface of semiconductor substrate 2, and if peripheral electrode 5 is made of a conductive substance containing aluminum, the aluminum is diffused from peripheral electrode 5 on the second surface of semiconductor substrate 2 to form p⁺ layer 8. Here, an alloy layer containing aluminum and silicon is formed between p⁺ layer 8 and peripheral electrode 5. This alloy layer is dense, and thus has the effect of reinforcing semiconductor substrate 2.

Next, as shown in step S9a, characteristics such as current-voltage characteristics of the solar cell after the firing are determined to check whether there are any problems, to complete the solar cell.

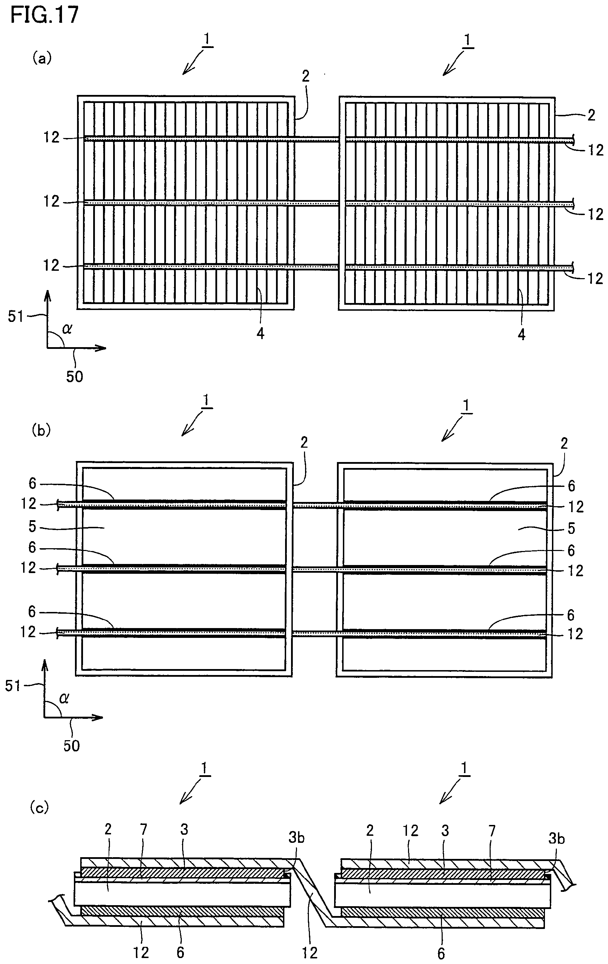

Fig. 17(a) shows a schematic plan view of an example of the light-receiving surfaces of a solar cell string of the present invention, which is made by connecting the plurality of solar cells 1 of the present invention to each other with connecting members 12. Fig. 17(b) shows a schematic plan view of an example of the rear surfaces of the solar cell string shown in Fig. 17(a). Fig. 17(c) shows a schematic cross-sectional view of the solar cell string having the light-receiving surfaces shown in Fig. 17(a) and the rear surfaces shown in Fig. 17(b).

The solar cell string shown in Figs. 17(a) to 17(c) has a structure in which one of adjacent solar cells 1 has busbar electrode 3 on the light-receiving surface electrically connected to connecting electrode 6 on the rear surface of the other solar cell 1 with connecting member 12. In this example, one solar cell 1 has three busbar electrodes 3 formed on the light-receiving surface and three connecting electrodes 6 formed on the rear surface. Additionally, in this example, busbar electrode 3, finger electrode 4 and connecting electrode 6 are made of silver, and peripheral electrode 5 is made of aluminum.

Connection between busbar electrode 3 on the light-receiving surface of solar cell 1 and connecting member 12, and connection between connecting electrode 6 on the rear surface of solar cell 1 and connecting member 12 can be established with a conventionally known method such as by the use of solder.

Since connecting member 12 has a constant width in this example, the width of connecting electrode 6 on the rear surface of solar cell 1 is larger than the width of busbar electrode 3 on the light-receiving surface of solar cell 1. By making the width of connecting electrode 6 on the rear surface of solar cell 1 larger than the width of busbar electrode 3 on the light-receiving surface of solar cell 1 in this manner, connection stability in connecting connecting member 12 that has been connected to busbar electrode 3 to connecting electrode 6 can be improved. The width of busbar electrode 3 is a length of busbar electrode 3 in the direction orthogonal to first direction 50, and the width of connecting electrode 6 is a length of connecting electrode 6 in the direction orthogonal to first direction 50.

In the solar cell string shown in Figs. 17(a) to 17(c) having the structure in which solar cells 1 of the present invention are connected to each other with connecting member 12 as described above, occurrence of a crack in semiconductor substrate 2 from the connection portion between connecting member 12 and busbar electrode 3 can be suppressed after connection with connecting member 12. Further, depending on an electrode pattern on the light-receiving surface of solar cell 1, not only occurrence of a crack in semiconductor substrate 2 from the connection portion between connecting member 12 and busbar electrode 3 but also occurrence of a crack in at least one of the above cases (2) and (3) can be suppressed during making of the solar cell string.

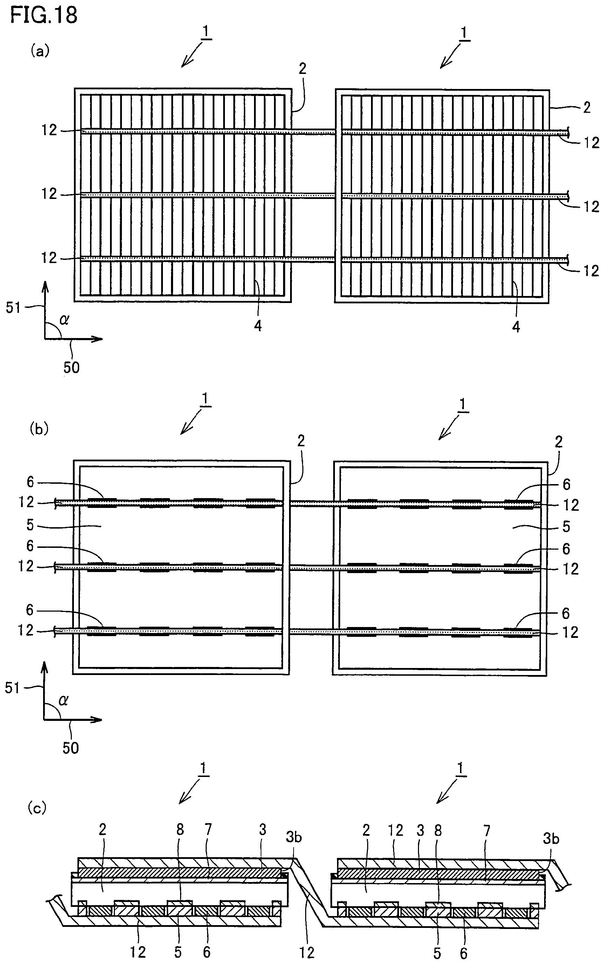

Fig. 18(a) shows a schematic plan view of another example of the light-receiving surfaces of the solar cell string of the present invention, which is made by connecting the plurality of solar cells 1 of the present invention to each other with connecting members 12. Fig. 18(b) shows a schematic plan view of another example of the rear surfaces of the solar cell string shown in Fig. 18(a). Fig. 18(c) shows a schematic cross-sectional view of the solar cell string having the light-receiving surfaces shown in Fig. 18(a) and the rear surfaces shown in Fig. 18(b).

The solar cell string shown in Figs. 18(a) to 18(c) has a structure in which one of adjacent solar cells 1 has busbar electrode 3 on the light-receiving surface electrically connected to connecting electrode 6 on the rear surface of the other solar cell 1 with connecting member 12. A feature of this example is that connecting electrode 6 on the rear surface of the solar cell string has the shape as shown in Fig.12, and that peripheral electrode 5 is positioned (connecting electrode 6 is not positioned) in a portion corresponding to the back of end portion 3b of busbar electrode 3. The structure is otherwise the same as that of the solar cell string shown in Figs. 17(a) to 17(c).

In the solar cell string shown in Figs. 18(a) to 18(c), peripheral electrode 5 is positioned (connecting electrode 6 is not positioned) in the portion corresponding to the back of end portion 3b of busbar electrode 3, thereby reinforcing semiconductor substrate 2 by peripheral electrode 5. In the solar cell string shown in Figs. 18(a) to 18(c), therefore, semiconductor substrate 2 can be reinforced by peripheral electrode 5 even upon generation of stress in semiconductor substrate 2 during making of the solar cell string, so that occurrence of a crack in semiconductor substrate 2 can be suppressed as compared to the solar cell string shown in Figs. 17(a) to 17(c).

The effect obtained by the solar cell string shown in Figs. 17(a) to 17(c) described above can also be obtained by the solar cell string shown in Figs. 18(a) to 18(c).

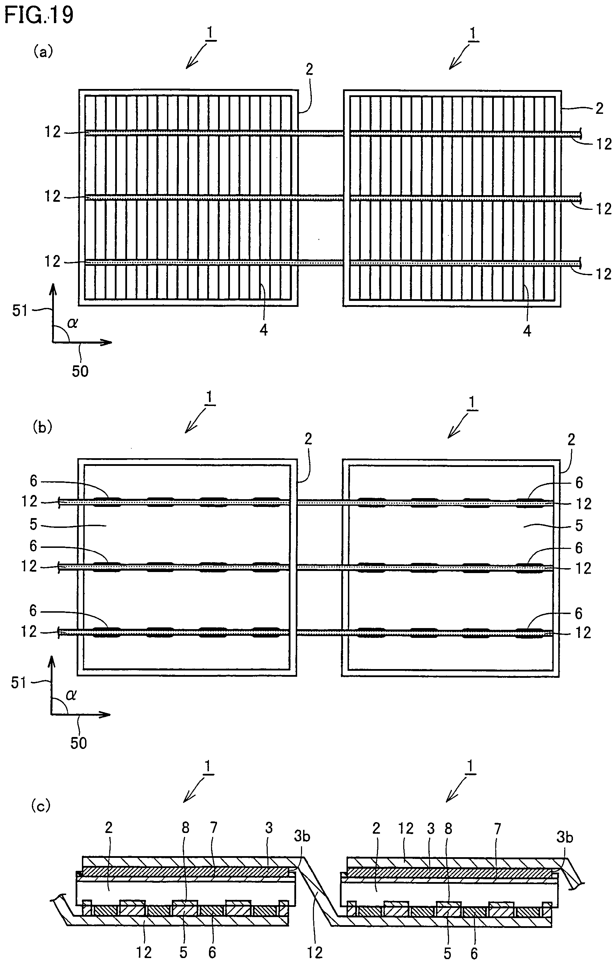

Fig. 19(a) shows a schematic plan view of another example of the light-receiving surfaces of the solar cell string of the present invention, which is made by connecting the plurality of solar cells 1 of the present invention to each other with connecting members 12. Fig. 19(b) shows a schematic plan view of another example of the rear surfaces of the solar cell string shown in Fig. 19(a). Fig. 19(c) shows a schematic cross-sectional view of the solar cell string having the light-receiving surfaces shown in Fig. 19(a) and the rear surfaces shown in Fig. 19(b).

The solar cell string shown in Figs. 19(a) to 19(c) has a structure in which one of adjacent solar cells 1 has busbar electrode 3 on the light-receiving surface electrically connected to connecting electrode 6 on the rear surface of the other solar cell 1 with connecting member 12. A feature of this example is that connecting electrode 6 on the rear surface of the solar cell string has the shape as shown in Fig. 10. The structure is otherwise the same as that of the solar cell string shown in Figs. 18(a) to 18(c).

The solar cell string shown in Figs. 19(a) to 19(c) includes solar cell 1 having connecting electrode end curved portion 6a, which is the side portion of connecting electrode 6 curved such that the width of connecting electrode 6 decreases toward the end portion of connecting electrode 6 in first direction 50 on the second surface of semiconductor substrate 2. This produces the effect of suppressing occurrence of a crack in semiconductor substrate 2 from the connection portion between connecting member 12 and connecting electrode 6 during making of the solar cell string.

The effect obtained by the solar cell string shown in Figs. 18(a) to 18(c) described above can also be obtained by the solar cell string shown in Figs. 19(a) to 19(c).

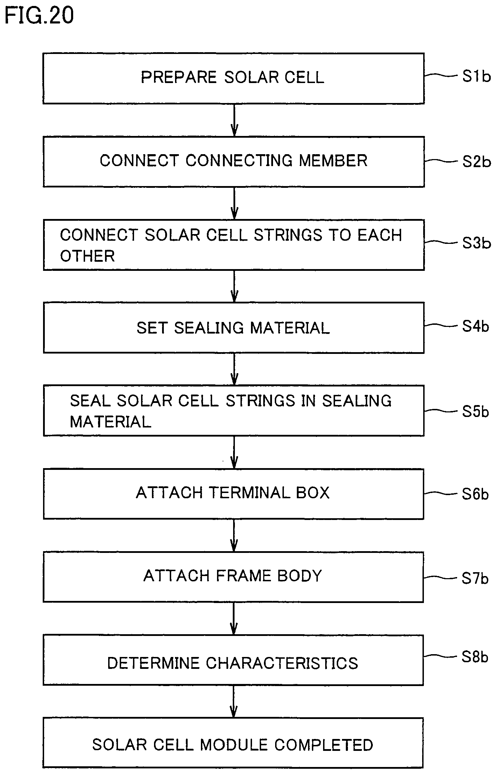

Fig. 20 shows a flowchart of an example of a method for manufacturing a solar cell module of the present invention by using the solar cell string of the present invention manufactured as described above.

First, as shown in step S1b, solar cell 1 having the above-described structure of the present invention is prepared. Next, as shown in step S2b, the plurality of solar cells 1 are connected to each other with connecting member 12 as described above, to manufacture the solar cell string having the above-described structure of the present invention.

Next, as shown in step S3b, the solar cell strings manufactured as above are electrically connected to each other with a conductive material, to connect the solar cell strings to each other.

Next, as shown in step S4b, the connected solar cell strings are disposed in a sealing material such as EVA (ethylene vinyl acetate), and the sealing material is disposed between a transparent substrate such as glass and a rear surface film such as a resin film, to set the sealing material.

Next, as shown in step S5b, the set sealing material is cured by heating the sealing material while applying pressure thereto in a vertical direction, to fabricate a solar cell module.

Next, as shown in step S6b, a terminal box is attached to the solar cell module with the cured sealing material. Next, as shown in step S7b, a frame body such as an aluminum frame is attached to surround the periphery of the solar cell module.

Next, as shown in step S8b, characteristics such as current-voltage characteristics of the solar cell with the frame attached thereto are determined to check whether there are any problems, to complete the solar cell module.

The n type and the p type may be exchanged with each other in the above description.

It should be understood that the embodiments disclosed herein are illustrative and non-restrictive in every respect. The scope of the present invention is defined by the terms of the claims, rather than the description above, and is intended to include any modifications within the scope and meaning equivalent to the terms of the claims.

### INDUSTRIAL APPLICABILITY

According to the present invention, a solar cell, a solar cell string and a solar cell module capable of achieving suppressed occurrence of a crack in a semiconductor substrate resulting from connection to a connecting member such as an interconnector can be provided.

## Claims

1. A solar cell (1) comprising:
a semiconductor substrate (2); and
a busbar electrode (3) extending in a first direction (50) and a finger electrode (4) extending in a second direction (51) on a first surface of said semiconductor substrate (2),
said finger electrode (4) and said busbar electrode (3) being electrically connected to each other, and
a side portion of said busbar electrode (3) being curved such that a width of said busbar electrode (3) increases toward an end portion of said busbar electrode (3), in a region near the end portion of said busbar electrode (3) in said first direction (50), and
a side portion of said finger electrode (4) is curved such that a width of said finger electrode (4) increases toward a connection portion between said finger electrode (4) and said busbar electrode (3), in a region near the connection portion between said finger electrode (4) and said busbar electrode (3).

2. The solar cell (1) according to claim 1, wherein
an angle formed between said first direction (50) and said second direction (51) is a right angle or substantially a right angle.

3. The solar cell (1) according to claim 1, further comprising on a second surface opposite to said first surface of said semiconductor substrate (2);
a connecting electrode (6) provided in an island shape for being electrically connected to a connecting member (12) of said solar cell (1); and
a peripheral electrode (5) provided to surround a periphery of said connecting electrode (6), wherein
a side portion of said connecting electrode (6) is curved such that a width of said connecting electrode (6) decreases toward an end portion of said connecting electrode (6) in said first direction (50), in a region near the end portion of said connecting electrode (6).

4. The solar cell (1) according to claim 3, wherein
said peripheral electrode (5) is positioned on said second surface, in a portion corresponding to the back of said end portion of said busbar electrode (3) in said first direction (50) on said first surface of said semiconductor substrate (2).

5. The solar cell (1) according to claim 3, wherein
said connecting electrode (6) is not positioned on said second surface, in a portion corresponding to the back of said end portion of said busbar electrode (3) in said first direction (50) on said first surface of said semiconductor substrate (2).

6. The solar cell (1) according to claim 3, wherein
the width of at least a portion of said connecting electrode (6) on said second surface of said semiconductor substrate (2) is larger than the width of said busbar electrode (3) in a region other than the region near the end portion of said busbar electrode (3) on said first surface of said semiconductor substrate (2).

7. The solar cell (1) according to claim 3, wherein
said connecting electrode (6) contains silver.

8. The solar cell (1) according to claim 3, wherein
said peripheral electrode (5) contains aluminum.

9. A solar cell string comprising a plurality of the solar cells (1) according to claim 1.

10. A solar cell module comprising the solar cell string according to claim 9.

## Patentansprüche

1. Solarzelle (1), umfassend:
ein Halbleitersubstrat (2); und
eine sich in einer ersten Richtung (50) erstreckende Stromschienenelektrode (3) und eine sich in einer zweiten Richtung (51) erstreckende Fingerelektrode (4) auf einer ersten Oberfläche des Halbleitersubstrats (2),
wobei die Fingerelektrode (4) und die Stromschienenelektrode (3) miteinander elektrisch verbunden sind, und
ein Seitenabschnitt der Stromschienenelektrode (3) so gekrümmt ist, dass eine Breite der Stromschienenelektrode (3) in Richtung eines Endabschnitts der Stromschienenelektrode (3) zunimmt, in einem Bereich nahe dem Endabschnitt der Stromschienenelektrode (3) in der ersten Richtung (50), und
ein Seitenabschnitt der Fingerelektrode (4) so gekrümmt ist, dass eine Breite der Fingerelektrode (4) in Richtung eines Verbindungsabschnitts zwischen der Fingerelektrode (4) und der Stromschienenelektrode (3) zunimmt, in einem Bereich nahe dem Verbindungsabschnitt zwischen der Fingerelektrode (4) und der Stromschienenelektrode (3).

2. Solarzelle (1) nach Anspruch 1, wobei
ein zwischen der ersten Richtung (50) und der zweiten Richtung (51) ausgebildeter Winkel ein rechter Winkel oder ein im Wesentlichen rechter Winkel ist.

3. Solarzelle (1) nach Anspruch 1, ferner umfassend, auf einer der ersten Oberfläche des Halbleitersubstrats (2) gegenüberliegenden zweiten Oberfläche:
eine Verbindungselektrode (6), die in Form einer Insel vorgesehen ist, um mit einem Verbindungselement (12) der Solarzelle (1) elektrisch verbunden zu werden; und
eine Peripherieelektrode (5), die so vorgesehen ist, dass sie einen Umfang der Verbindungselektrode (6) umgibt, wobei
ein Seitenabschnitt der Verbindungselektrode (6) so gekrümmt ist, dass eine Breite der Verbindungselektrode (6) in Richtung eines Endabschnitts der Verbindungselektrode (6) in der ersten Richtung (50) abnimmt, in einem Bereich nahe dem Endabschnitt der Verbindungselektrode (6).

4. Solarzelle (1) nach Anspruch 3, wobei
die Peripherieelektrode (5) auf der zweiten Oberfläche in einem Abschnitt positioniert ist, der der Rückseite des Endabschnitts der Stromschienenelektrode (3) in der ersten Richtung (50) auf der ersten Oberfläche des Halbleitersubstrats (2) entspricht.

5. Solarzelle (1) nach Anspruch 3, wobei
die Verbindungselektrode (6) nicht auf der zweiten Oberfläche in einem Abschnitt positioniert ist, der der Rückseite des Endabschnitts der Stromschienenelektrode (3) in der ersten Richtung (50) auf der ersten Oberfläche des Halbleitersubstrats (2) entspricht.

6. Solarzelle (1) nach Anspruch 3, wobei
die Breite zumindest eines Abschnitts der Verbindungselektrode (6) auf der zweiten Oberfläche des Halbleitersubstrats (2) größer ist als die Breite der Stromschienenelektrode (3) in einem anderen Bereich als dem Bereich nahe dem Endabschnitt der Stromschienenelektrode (3) auf der ersten Oberfläche des Halbleitersubstrats (2).

7. Solarzelle (1) nach Anspruch 3, wobei
die Verbindungselektrode (6) Silber enthält.

8. Solarzelle (1) nach Anspruch 3, wobei
die Peripherieelektrode (5) Aluminium enthält.

9. Solarzellenstrang, umfassend eine Vielzahl von Solarzellen (1) nach Anspruch 1.

10. Solarzellenmodul, umfassend den Solarzellenstrang nach Anspruch 9.

## Revendications

1. Cellule solaire (1) comprenant :
un substrat semi-conducteur (2) ; et
une électrode barre collectrice (3) qui s'étend dans une première direction (50) et une électrode en forme de doigt (4) qui s'étend dans une deuxième direction (51) sur une première surface du substrat semi-conducteur (2),
l'électrode en forme de doigt (4) et l'électrode barre collectrice (3) étant reliées électriquement entre elles, et
une partie latérale de l'électrode barre collectrice (3) étant courbe de telle sorte qu'une largeur de ladite électrode barre collectrice (3) augmente en direction d'une partie d'extrémité de ladite électrode barre collectrice (3), dans une zone proche de la partie d'extrémité de l'électrode barre collectrice (3) dans la première direction (50), et
une partie latérale de l'électrode en forme de doigt (4) étant courbe de telle sorte qu'une largeur de ladite électrode en forme de doigt (4) augmente en direction d'une partie de liaison entre ladite électrode (4) et l'électrode barre collectrice (3), dans une zone proche de la partie de liaison entre l'électrode en forme de doigt (4) et l'électrode barre collectrice (3).

2. Cellule solaire (1) selon la revendication 1, dans laquelle un angle formé entre la première direction (50) et la deuxième direction (51) est un angle droit ou globalement un angle droit.

3. Cellule solaire (1) selon la revendication 1, comprenant également sur une deuxième surface opposée à la première surface du substrat semi-conducteur (2)
une électrode de liaison (6) qui présente la forme d'un îlot pour être reliée électriquement à un élément de liaison (12) de la cellule solaire (1) ; et
une électrode périphérique (5) qui est disposée de manière à entourer une périphérie de l'électrode de liaison (6),
une partie latérale de l'électrode de liaison (6) étant courbe de telle sorte qu'une largeur de ladite électrode (6) diminue en direction d'une partie d'extrémité de ladite électrode de liaison (6) dans la première direction (50), dans une zone proche de la partie d'extrémité de l'électrode de liaison (6).

4. Cellule solaire (1) selon la revendication 3, dans laquelle l'électrode périphérique (5) est positionnée sur la deuxième surface, dans une partie qui correspond à l'arrière de la partie d'extrémité de l'électrode barre collectrice (3), dans la première direction (50), sur la première surface du substrat semi-conducteur (2).

5. Cellule solaire (1) selon la revendication 3, dans laquelle l'électrode de liaison (6) n'est pas positionnée sur la deuxième surface, dans une partie qui correspond à l'arrière de la partie d'extrémité de l'électrode barre collectrice (3), dans la première direction (50), sur la première surface du substrat semi-conducteur (2).

6. Cellule solaire (1) selon la revendication 3, dans laquelle la largeur d'une partie au moins de l'électrode de liaison (6) sur la deuxième surface du substrat semi-conducteur (2) est plus grande que la largeur de l'électrode barre collectrice (3) dans une zone différente de la zone proche de la partie d'extrémité de l'électrode barre collectrice (3) sur la première surface du substrat semi-conducteur (2).

7. Cellule solaire (1) selon la revendication 3, dans laquelle l'électrode de liaison (6) contient de l'argent.

8. Cellule solaire (1) selon la revendication 3, dans laquelle l'électrode périphérique (5) contient de l'aluminium.

9. Chaîne de cellules solaires comprenant plusieurs cellules solaires (1) selon la revendication 1.

10. Module de cellules solaires comprenant la chaîne de cellules solaires selon la revendication 9.
